Europäisches Patentamt

European Patent Office

Office européen des brevets

(19)

(11) Publication number: **0 032 208**
**A2**

(12) # EUROPEAN PATENT APPLICATION

(21) Application number: **80107813.0**

(22) Date of filing: **11.12.80**

(51) Int. Cl.³: **G 11 C 19/08**

(30) Priority: **14.01.80 US 111756**

(43) Date of publication of application:
**22.07.81 Bulletin 81/29**

(84) Designated Contracting States:
**DE FR GB IT SE**

(71) Applicant: **Rockwell International Corporation**
**2230 East Imperial Highway**
**El Segundo, California 90245(US)**

(72) Inventor: **Beyerlein, Fritz Werner**
**9401 Olympus Court**
**Sunnyvale California(US)**

(74) Representative: **Wagner, Karl H.**
**P.O. Box 246 Gewüerzmuehlstrasse 5**
**D-8000 München 22(DE)**

(54) Magnetic bubble domain device package and method of assembly.

(57) A magnetic bubble domain device package and method of assembly thereof in which an integral rigid carrier is configured for receiving a magnetic bubble domain device chip and provides a frame for directly winding the drive coils thereon. The carrier also includes predetermined positions for the placement of bias magnets so as to obtain a uniform bias field directed at a predetermined angle with respect to the chip. The rigid carrier is preferably injection molded to provide highly precise dimensions and placement of the various components of the package.

FIG I

EP 0 032 208 A2

Croydon Printing Company Ltd.

MAGNETIC BUBBLE DOMAIN DEVICE PACKAGE AND METHOD OF
ASSEMBLY

This invention relates to magnetic bubble domain device
assemblies and more particularly to a new and improved bubble
memory package, and the method of assembling such package.

A magnetic bubble domain device package comprises one
or more chips or modules known as magnetic bubble domain devices
containing a thin layer of garnet-like material formed on a
substrate and disposed between bias magnets which provide a bias
field to the plane of the substrate to establish and maintain
magnetic bubble domains in the garnet-like material. For bubble
movement (propagation) in the plane of garnet-like material, drive
coils are provided which produce rotational in-plane magnetic
fields. The coils themselves are positioned to surround the
substrate. Means are also provided to interconnect the chips to
one another (if there is more than one chip in the package), to
connect to the control circuitry for performing various bubble
menipulations in the chips, and to connect the devices to the
outside world.

In the prior art, one configuration for connecting
the bubble domain chip to the outside world is a rigid ceramic
or plastic printed carrier on which the chip is mounted. The PC
carrier would be connected by wires or other suitable conductors
to external pins or other connectors.

One example of such a typical prior art bubble domain
device package is known as an "E-carrier" since it consists of
a generally.E-shaped rigid or flexible insulating film
interconnect member having a chip-supporting central portion. The E-carrier has two longitudinal slots on opposite sides thereof, thereby defining parallel leg portions spaced apart from the central chip-supporting portion on opposite sides thereof. A plurality of narrow-line conductors are disposed on the surface of the interconnect member which provide external access to the magnetic bubble domain chip through leads bonded to the conductors along the leg portions of the interconnect member. The interconnect member with a magnetic bubble domain chip bonded thereto on the central chip-supporting portion is then encapsulated in a thin film of molding material, thereby making the structure rigid so as to support the field coils.

A set of orthogonally wound drive field coils is provided on the E-carrier, the first pre-wound coil being slipped around the encapsulated magnetic bubble domain chips as mounted on the central portion of the interconnect member of the molded assembly through the longitudinal slots of the assembly and the pre-wound second coil with a slightly larger spacing is slipped around the first coil in orthogonal relationship thereto. The coils are separated from the magnetic bubble domain chip by a thin film of the molding material or the interconnect foil. In addition, the structural geometric configuration of the molded assembly in association with the interconnect member enables the magnetic bubble domain chip to be typically located in the geometric center of the drive field coils.

A magnetic bias field perpendicular to the plane of the chip and which maintains the magnetic bubbles in a nonvolatile state is typically provided within the housing by two permanent magnets attached inside the housing.

## PRIOR ART STATEMENT

The prior art known to applicant and having some relevance to the instant invention is listed herewith.

U. S. Patent No. 3,864,671 which apparently relates to a magnetic bubble device package fabricated from a material that combines the properties of electrical insulation and magnetic remanence, preferably a ceramic.

U. S. Patent No. 4,012,723 which apparently relates to a magnetic bubble device package including a transfer injection molded frame on which the field coils may be wound.

U. S. Patent No. 4,017,604 which apparently relates to a magnetic bubble device packaging assembly including a module assembly board for receiving a plurality of magnetic bubble chips.

U. S. Patent No. 4,090,252 which apparently relates to an improved rotational field generating apparatus for a bubble memory package.

U. S. Patent No. 4,110,838 which apparently relates to a magnetic bubble domain package using a thin film of insulating material with the chip secured to the film to produce a co-planar relationship between the surface of the chip and the signal leads.

U. S. Patent No. 4,150,440 which apparently describes a magnetic bubble memory package which functions as a heat sink formed with a pocket therein for receiving the field coil assembly including the chip carrier assembly of the magnetic bubble domain device.

U. S. Patent No. 4,160,274 which apparently relates to a magnetic bubble domain package including a thin film interconnect member including conductors thereon to which the bubble domain chip is bonded.

U. S. Patent No. 4,165,535 which apparently relates to a drive assembly using a picture frame type magnetic core.

U. S. Patent No. 4,165,536 which apparently relates to a magnetic bubble device package which includes a printed circuit board for supporting the chips and a flexible portion containing conductors for direct connection with the chips.

## SUMMARY OF THE INVENTION

Briefly and in general terms the invention is concerned with magnetic bubble domain device packages, and in particular with a package comprising an integral injection molded rigid frame member, and the method of assembling the package.

The present invention provides a magnetic bubble domain package including a rigid carrier having a cavity therein designed for receiving a magnetic bubble domain chip and providing a frame for directly winding the drive coils thereon. The carrier also includes predetermined alignment means for the placement of bias magnets so as to obtain a uniform bias field directed at a predetermined angle (different from a right angle) with respect to the chip. The rigid carrier is preferably injection molded as a single piece to provide highly precise dimensions and the relative placement of the various components of the package. The present invention further provides a flexible interconnect member having a conductive layer on one major surface thereof which engages the rigid carrier and makes physical and electrical contact with the chip.

The invention is also concerned with a method of assembling the magnetic bubble domain package including the steps of providing a magnetic bubble domain chip on a carrier; winding coils on the carrier so as to surround the magnetic bubble domain chip so as to produce an in-plane rotary magnetic field at the surface of the magnetic bubble domain chip in response to electrical energization thereof; and disposing a magnetic bias field generator on the carrier in a spaced relation to the magnetic bubble domain chip for producing a magnetic field at a predetermined angle with respect to the surface of the chip.

The novel features which are considered·as characteristic for the invention are set forth in particular in the appended claims. The invention itself, however, both as to its construction and its method of operation, together with additional objects and advantages thereof will be best understood from the following description of specific embodiments when read in connection with the accompanying drawings.

## BRIEF DESCRIPTION OF THE DRAWING

FIGURE 1 is a perspective view of the rigid frame member component of the magnetic bubble domain package according to the present invention;

FIGURE 2 is a top plan view of the rigid frame member component of FIGURE 1;

FIGURE 3 is an end view of the rigid frame member component of FIGURE 1;

FIGURE 4 is a cross-sectional view of the rigid frame member component of FIGURE 1 through the 4-4 plane;

FIGURE 5 is a cross-sectional view of the rigid frame member component of FIGURE 1 through the 5-5 plane;

FIGURE 6 is a bottom plan view of the rigid frame member component of FIGURE 1;

FIGURE 7 is a top plan view of the·flexible interconnect member component of the magnetic bubble domain package according to the present invention;

FIGURE 8 is a perspective view of the rigid frame member component with one portion of the flexible interconnect member placed therein;

FIGURE 9 is a perspective view of the partially assembled magnetic bubble domain package according to the present invention with the first coil being wound into place;

FIGURE 10 is a perspective view of the partially assembled magnetic bubble domain package according to the present invention with the "arms" of the flexible interconnect member folded back for the second coil winding;

FIGURE 11 is a perspective view of the partially assembled magnetic bubble domain package according to the present invention after both coils have been wound in place and the arms of the flexible interconnect member retracted to their normal position, with the upper and lower permanent magnetic positioned for assembly in the package; and

FIGURE 12 is a perspective view of the partially assembled magnetic bubble domain package according to the present invention similar to FIGURE 11 but with the external lead frame attached.

In the various FIGURES, like reference numerals refer to like parts.

## DESCRIPTION OF THE PREFERRED EMBODIMENT

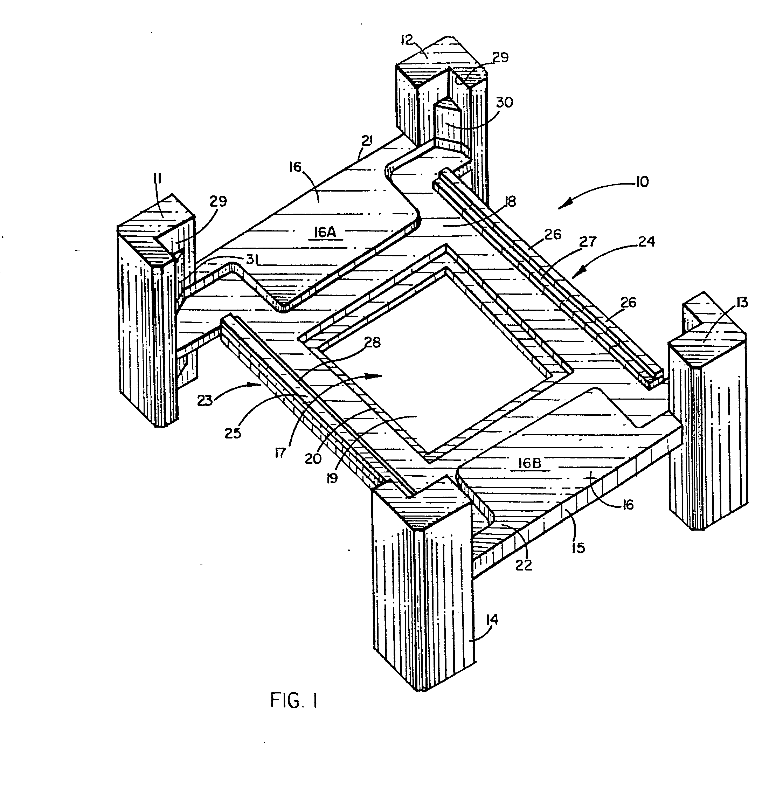

Turning now to FIGURE 1 there is shown a perspective view of the rigid frame member component 10 of the magnetic bubble domain package according to the present invention. The frame component 10 is preferably an integral injection-molded member composed of synthetic plastic material which is formed to a highly precise, predetermined configuration and dimension. The purpose of the frame component 10 is to provide a support for the magnetic bubble domain chip so that the chip is held in a specific position with respect to other electrical and magnetic package components. These components include the interconnect member, the drive field coils, the permanent magnets and the shield. The structural member 10 includes cavities which are adapted to receive the magnetic bubble domain chip and a flexible interconnect member component which provides a beam-tape type bond to the magnetic bubble domain chip. These cavities, together with the interconnect component will be described in greater detail subsequently.

The frame component 10 is preferably configured in a substantially rectangular shape, with four end posts 11, 12, 13, and 14 at each corner of the frame component 10. The frame component 10 also includes a plate 15 suspended between the four posts 11, 12, 13, and 14. In the preferred embodiment, the posts 11, 12, 13, and 14 are of the same length, are disposed parallel to one another, and are aligned so that the top end portion of each of the posts lies on a first plane (not shown), while the bottom end portion of each of the posts lie on a second plane (not shown) parallel to the first plane.

A plate 15 is disposed between each of the posts 11, 12, 13, and 14 which forms a substantially plane surface in the central portion of the carrier. The plate 15 is tilted at a predetermined angle with respect to the first and second planes described above. The plate 15 includes a substantially planar major surface 16 with a preferably rectangular shaped central first cavity 17 which is configured and dimensioned to receive a magnetic bubble domain chip of a given size and shape. The first major surface 16 of the plate 15 also includes a second preferably "X" shaped cavity 18 configured and dimensioned to receive the interconnect component.

The first cavity 17 is preferably formed as an aperture 19 in the center of the plate 15 including a relatively narrow ledge 20 circumferentially surrounding the aperture 19 at its perimeter. The magnetic bubble domain chip (not shown) is rectangularly shaped and adapted to be placed in the cavity 17 so that the bottom major surface rests on the ledge 20 and is supported thereby. The top major surface of the bubble domain chip, including the electrical contact pads, is preferably coplanar with the major surface 16 of the plate 15.

The plate 15 also includes an "X" shaped second cavity 18 which generally surrounds the first cavity 17. The major surface of the cavity 18 is substantially planar with the top major surface of the magnetic bubble domain chip when the chip is inserted in the cavity 17. On two opposed end portions 21 and 22 of the plate 15 are provided two surface portions 16A and 16B which together form the major surface 15 of the plate 15. These portions 16A and 16B form the core around which the first coil is wound, as will be explained and shown subsequently.

The plate 15 also includes a third end portion 23 and a fourth end portion 24. Along the edge of the third end portion 23 is disposed a ledge 25 which extends from the edge of the third end portion 23 in a direction to the surface of the cavity 18 to a height above the surface greater than the height of the portions 16A and 16B above the cavity 18. The ledge 25 also extends parallel to the surface of the cavity 18 in a direction from the edge so as to form a uniform step-shaped configuration with the lower step 28 being essentially coplanar with the surface 15.

The lower step 28 is designed to engage the first and second turns of the first coil of wire which extends from the surface portion 16B to the surface portion 16A. The edge of the step is therefore configured as parallel to the end portions 23,24 of the plate 15.

On the other end portion 24 of the carrier 10 is provided a similarly step-shaped ledge 26 which also includes a step 27. Like the step 28, the step 27 is designed to align with the outermost turns of the first coil of wire which extends between the surface portions 16A and 16B.

The upper surfaces of the ledges 25 and 26 form the region in which the second layer of coil is wound.

The winding of the first and second coils directly on the frame in the present invention rather than using pre-wound coils as in the prior art offers a number of important advantages. One important advantage is the tighter control over the tolerances of the coil size. The coil size is important since the coils should be disposed as close to the chip as possible in order to reduce power consumption.

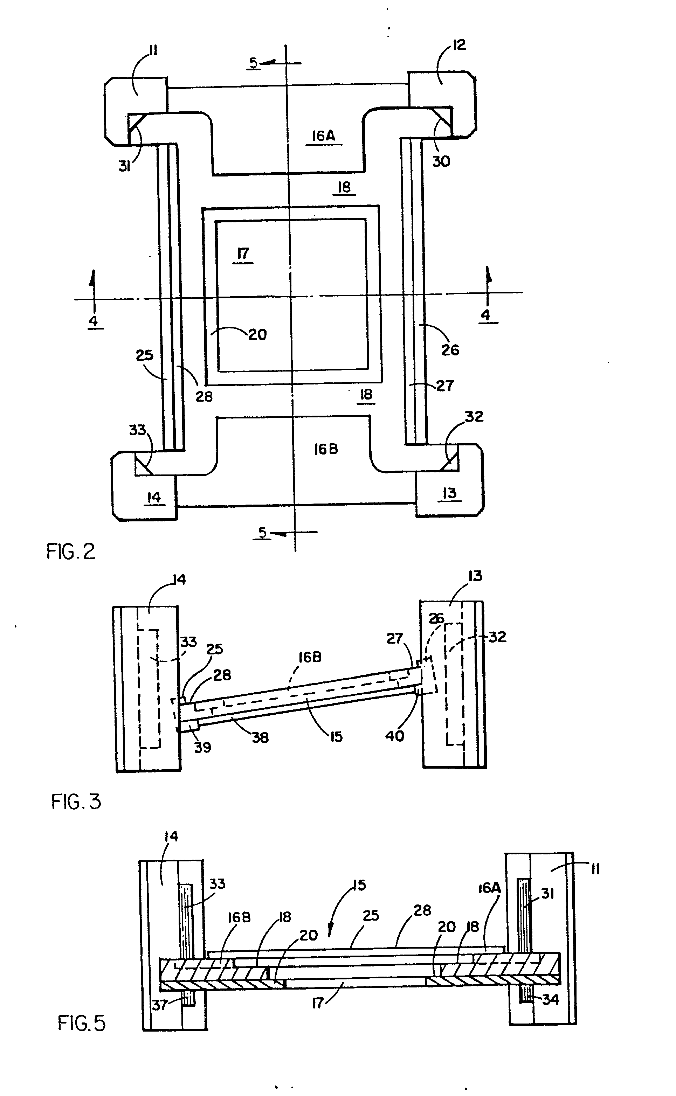

Turning now to FIGURE 2 there is shown a top plan view of the rigid frame member component of FIGURE 1. Many of· the elements shown in FIGURE 1 are also shown in FIGURE 2, including the four posts 11, 12, 13, and 14, the first cavity 17 and the second cavity 18, the major surface 16 including surface portions 16A and 16B. The ledges 25 and 26 together with the lower steps 27 and 28 for the outermost strands of wire of the first coil are also illustrated.

Each of the posts 11, 12, 13, and 14 include a corresponding ledge thereon designated by 30, 31, 32, and 33 respectively. Each ledge is positioned a predetermined distance away from the top of the corresponding post.

One of the permanent magnets which form part of the package according to the present invention is then positioned on the ledges 30, 31, 32, and 33.

FIGURE 3 is an end view of the rigid frame member component 10 in the direction formed by the end posts 13 and 14. The tilt of the plate 15 with respect to the end posts 13 and 14 is clearly shown in this view.

The plate 15 preferably tilts at an angle of approximately $5^{o}$ with respect to the normal to the end posts. The purpose of the tilt is to provide a magnetic field gradient in the plane of the plate when the in-plane field is energized so that the bubbles in the plate have a tendency to move in a predetermined direction.

The substantially planar surface 16B, together with the substantially planar lower surface 38, parallel to the upper surface 16B, are also shown. The various ledges 25 and 26 together with the steps 27 and 28 on the upper portion of the plate 15 are shown, together with corresponding ledges 39 and 40 on the lower surface 38 of the plate 15.

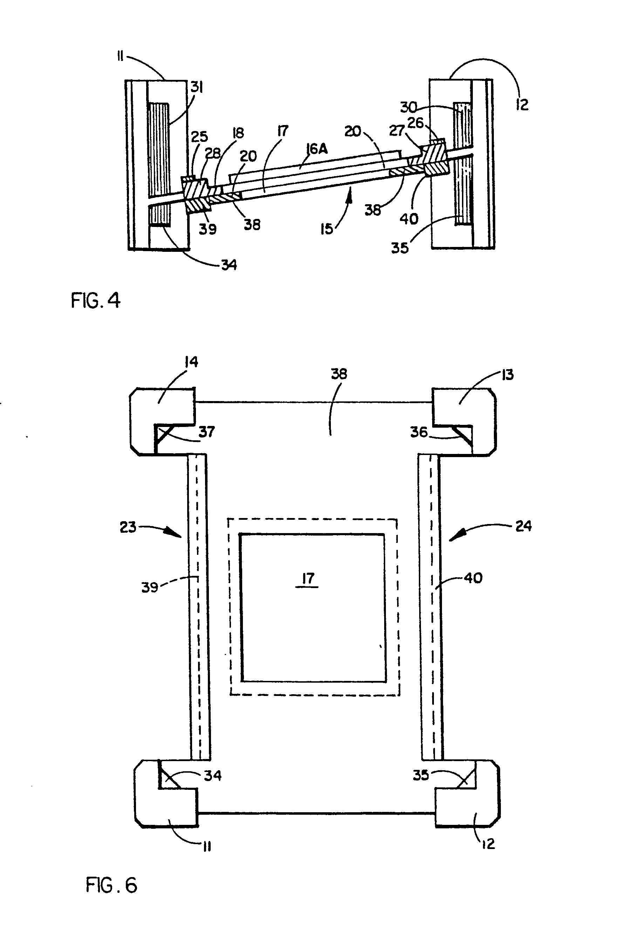

Turning now to FIGURE 4 there is shown a cross-sectional view of the rigid frame member component 10 through the 4-4 plane shown in FIGURE 2. The end posts 11 and 12 are now seen in the background together with the ledges 31 and 30 respectively associated with the upper portions therewith. On the lower portion of the posts 11 and 12 are shown ledges 34 and 35 respectively associated therewith. The ledges 34 and 35 like the ledges 31 and 30 are positioned a specific predetermined distance away from the bottom of the corresponding posts 11 and 12. The ledges 34 and 35 provide alignment of the lower permanent magnet in the carrier 10.

The plate 15 is seen tilted with respect to the posts 11 and 12 at the same predetermined angle as shown in the end view of FIGURE 3. The various layers of the plate 15 are also seen to be parallel in the same manner as in FIGURE 3, namely the major surface portion 16A which is substantially coplanar with the major surface portion 16B; the surface of the second cavity 18 and the ledge 20. Each of these surfaces 16, 18, and 20 are parallel to one another. The aperture 17 is also shown peripherally surrounded by the ledge 20.

The various ledges 25 and 26, 39 and 40, and the steps 27 and 28 are also shown. Such components are again the same configuration and dimension as that in FIGURE 3.

Turning now to FIGURE 5 there is shown a cross-sectional view of the rigid frame member component 10 of FIGURE 1 through the 5-5 plane in FIGURE 2. Now the posts 11 and 14 are shown in the background with the ledges 31 and 33 respectively on the upper portions thereof and the ledges 34 and 37 on the lower portions thereof. The plate 15 is seen to be disposed parallel to the first plane (not shown) formed by the top end portions of the posts 11 and 14, as well as parallel to the second plane (not shown) formed by the bottom end portions of the posts 11 and 14. The surfaces formed by the ledges 25, the surfaces 16A and 16B, the surface formed by the cavity 18, the surface formed by the ledges 20 are also shown to be parallel to one another. The aperture 17 is also shown surrounded by the ledge 20.

FIGURE 6 is a bottom plan view of the rigid frame member component as shown in FIGURE 1. The end posts 11, 12, 13, and 14 are shown together with a substantially planar bottom surface 38. Similar to the configuration from the top plan view, each of the posts 11, 12, 13, and 14 includes a corresponding ledge in a corner formed by a concave portion of each respective post facing the interior of the carrier. These ledges are identified as 34, 35, 36, and 37 associated to posts 11, 12, 13 and 14 respectively. Each of the ledges 34, 35, 36 and 37 are positioned a specific distance away from the bottom surface of the corresponding post. As is suggested from FIGURE 5 above, the distance between such ledge and the bottom surface of the post is preferably equal to the distance between the ledges on the top surface of the posts 31, 32, 33 and 34 and the top surface as such posts.

The bottom plane surface 38 also includes ledges 39 and 40 which are situated on the edges 23, and 24 of the surface 38 respectively, similar to the ledges 25 and 26 on the top surface. The ledges 39 and 40 are similarly sized and shaped as the ledges 25 and 26 but does not include the lower steps 28 and 27 since the inner coil lies flat against the surface 38 on the bottom surface. The aperture 17 is also shown in FIGURE 6.

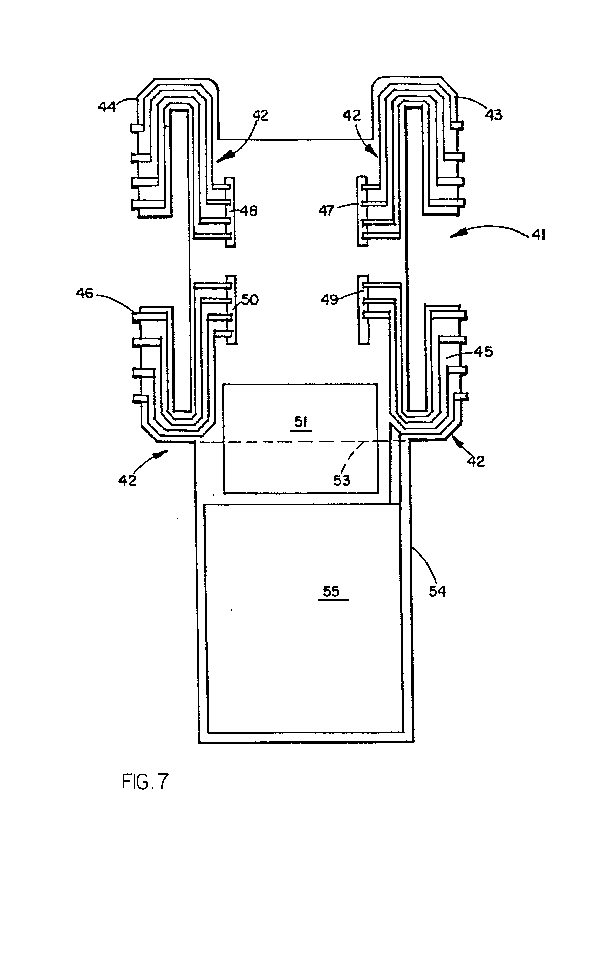

Turning now to FIGURE 7 there is shown a plan view of the flexible interconnect member component 41 of the magnetic bubble domain package according to the present invention. The flexible interconnect member is preferably composed of a polyimid film about 3 mils in thickness. On the top surface of the film is deposited a first metallization pattern 42 composed of any suitable conductor. In the preferred embodiment the conductor is either copper or gold which is 3 mils in thickness and deposited in the multiple strip configuration as shown.

The flexible interconnect member component 41 is basically a rectangularly shaped sheet with a first portion 58 including four arms 43, 44, 45, and 46 projecting from four portions of the sheet in positions corresponding to the posts 11, 12, 13, and 14 respectively.

The flexible interconnect member component 41 also includes, for example, four apertures 47, 48, 49, and 50 which are disposed in the region corresponding to where the edges of the magnetic bubble domain chip will lie when the flexible interconnect member component is positioned in the carrier 10. The first metallization 42 on the flexible interconnect member is partitioned into a suitable number of spaced apart portions, preferably narrow conductor strips extending from the apertures 47, 48, 49, and 50 to the outer edges of the corresponding arms 43, 44, 45, and 46 respectively. Such metal strips makes electrical connection between specific contact pads on the magnetic bubble domain chip which are disposed beneath the apertures 47, 48, 49, and 50 when the flexible interconnect member 41 is placed thereover. In the preferred embodiment the strips formed by the conductive layer 42 cantilever over the edges of the top surface of the interconnect member 41 into the apertures 47, 48, 49, and 50 so as to more readily allow electrical contact to be made between the contact pads on the chip therebeneath and the discrete spaced-apart portions of the conductive layer 42. The actual bond between the pads on the magnetic bubble domain chip and the cantilevered spaced-apart strips of the conductive layer 42 may be formed by thermo-compression bonding or any suitable technique known in the art.

An external lead frame 60 is positioned to engage the outer portion of the arms 43, 44, 45, and 46. The lead frame 60 is positioned on the carrier by any suitable means, and the individual metal conductors bonded to the cantilevered conductors extended over the edge of the flexible interconnect member. The bond between the external lead frame (not shown) and the cantilevered discrete spaced apart strips of the conductive layer 42 on the external portions of the arms 43, 44, 45, and 46 is also formed by thermo-compression bonding or other suitable technique known in the art.

A second portion 54 of the flexible interconnect member 41 is a substantially rectangularly shaped member designed to be placed over the first portion 58 after the first portion is inserted into the carrier 10. This second portion 54 may be separated from the first portion of the flexible interconnect member component by cutting across the line 53, or alternatively the second portion 54 may simply be folded along the line 53.

As is shown in FIGURE 7 there is a relatively large rectangularly shaped aperture 51 in the central portion of the flexible interconnect member 41 which corresponds to the 16A or 16B portion when the member 41 is inserted into the carrier 10. The second portion 54 contains an essentially rectangularly shaped second metallization pattern 55 which is designed to overlie the chip when inserted into the carrier 10. Such a second metallization pattern is designed to provide a more uniform magnetic field at the surface of the chip as well as to provide electrostatic shielding of the chip from external fields.

The second metallization pattern 55 is preferably connected to one of the strips of the conductive layer 42, which is preferably connected to ground.

An alternative method of fabrication is to make the flexible interconnect member in two separate pieces, although such a member is not shown in the drawing.

The flexible interconnect member 41 is either simply folded or cut along the dotted line shown in FIGURE 7 and both portions 58 and 54 inserted into the carrier 10 so that it fits into the cavity 18 on the upper surface and makes physical and electrical contact with the magnetic bubble domain device chip placed in the cavity 17.

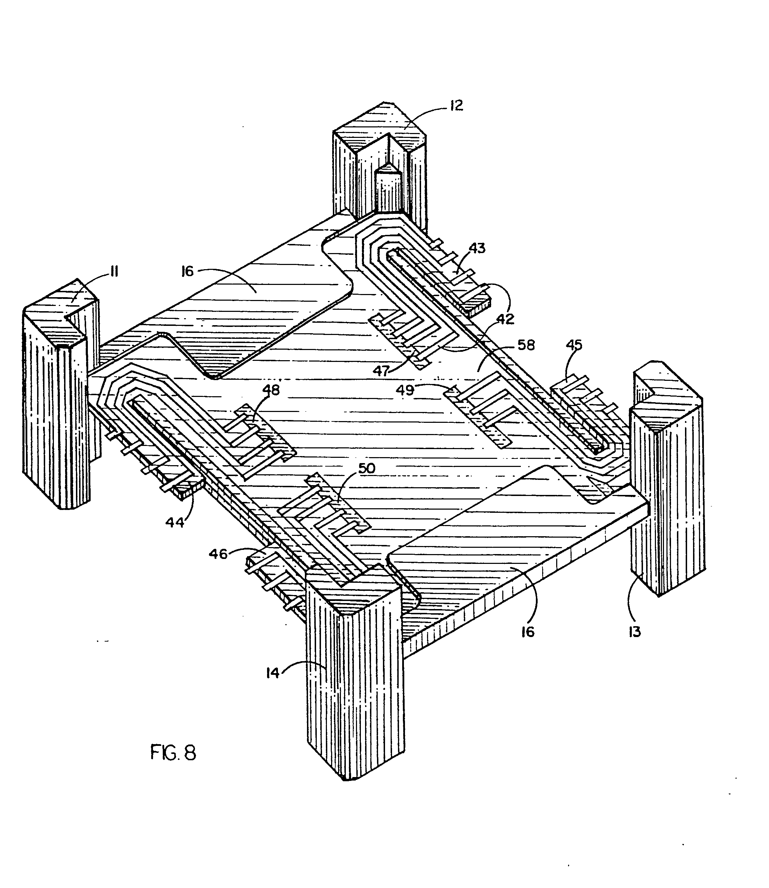

FIGURE 8 is a perspective view of the rigid frame member with the first portion 58 of the flexible interconnect member placed therein. As we noted above, the conductive layer 42 of the first portion 58 of the flexible interconnect member is partitioned into a discrete number of spaced apart portions. The spaced apart portions are designed to make electrical contact with corresponding electrical contacts or pads on the magnetic bubble domain chip so as to enable selective actuation of specific magnetic bubble domain functions associated therewith. The conductors on the flexible interconnect member cantilever over the surface of the flexible interconnect member into the open apertures 47, 48, 49, and 50, where they are bonded to contact pads on the chip lying directly under the apertures.

Once the first portion 58 of the flexible interconnect member is placed in the cavity 18 and the conductors bonded to the contact pad on the chip, the second portion 54 is placed thereover.

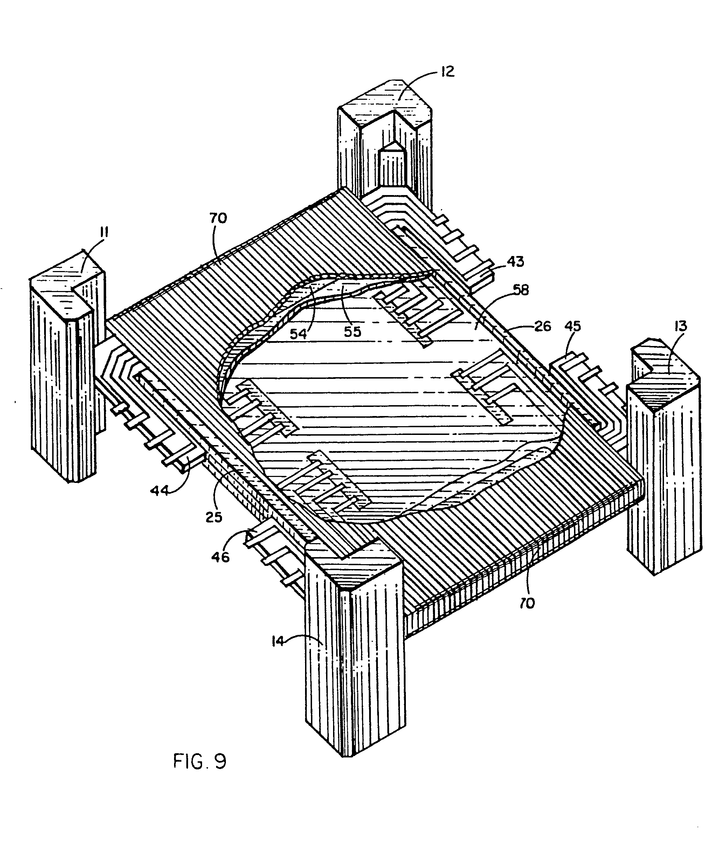

FIGURE 9 is a perspective view of the partially assembled bubble domain package according to the present invention with the first coil 70 being wound in place.

Through a cut-out illustrated in the first coil 70 there is shown the first portion 58 of the flexible interconnect member, and a cut-out portion of the second portion 54 of the flexible interconnect member, including the layer 55.

It should be noted that the first coil 70 lies flush with the bottom surface 38 of the carrier and along the steps 28 and 27 as well as the upper surfaces 16A and 16B on the upper surface of the plate 15 (as shown in FIGURES 1 and 3).

The first coil 70 is preferably composed of an insulating copper wire 5 to 10 mils in diameter and wound around the plate 15 from one edge to the opposite edge of the carrier to a thickness of two layers.

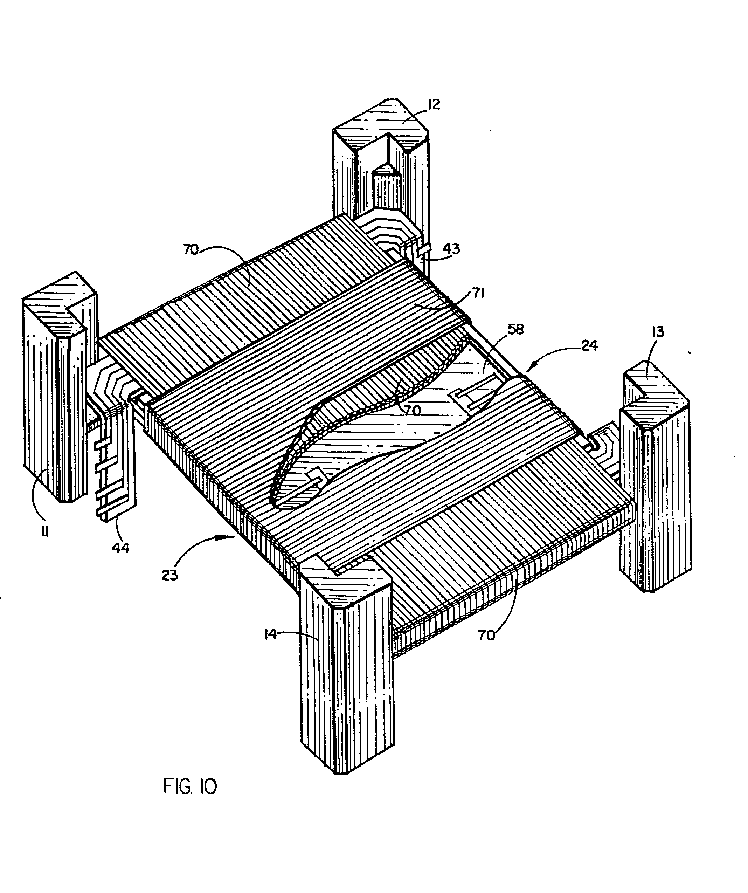

FIGURE 10 is a perspective view similar to that of FIGURE 9 with the arms of a flexible interconnect member folded back for the second coil winding. The arms 43, 44, 45 and 46 are folded back by an external tool (not shown) for winding the second coil 71.

FIGURE 10 is a perspective view similar to that of FIGURE 9 with the second coil 71 being wound into place. The second coil 71 is wound around the edges 23 and 24 of the plate 15 orthogonal to the first coil 70. The second coil, like the first coil, is preferably composed of an insulated copper conductor 1 mil in diameter and wound around the plate 15 a suitable number of turns typically to a thickness of two layers. Leads from both of the coils extend to selectively positioned terminal conductors (not shown) which are for making external connection thereto.

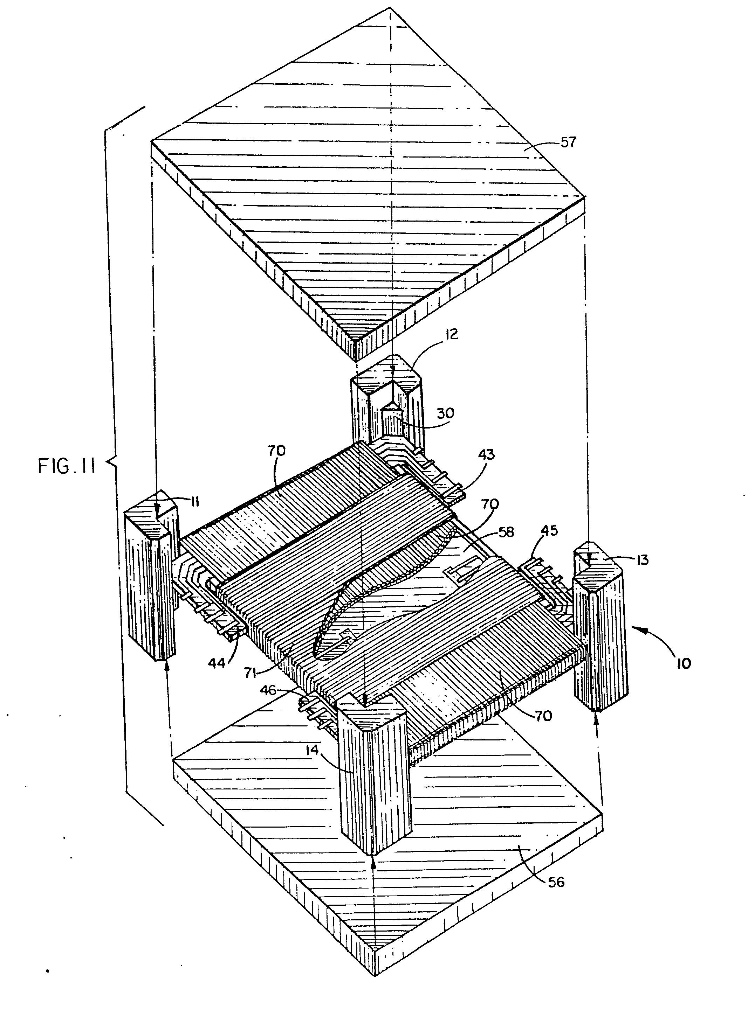

FIGURE 11 is an exploded perspective view of the partially assembled bubble domain package after both coils have been wound in place and the arms 43, 44, 45, and 46 of the flexible interconnect member retracted to their normal position.

The lower permanent magnet 56 is positioned on the four ledges 34, 35, 36, and 37 (shown in FIGURE 6) of the lower portion of the carrier 10. The permanent magnet 56 preferably includes a thin layer of ferrite material on one of the major surfaces thereof for the purpose of providing a more uniform magnetic field. A similarly sized and configured upper permanent magnet 57 is provided on the upper portion of the carrier 10. The upper permanent magnet 57 is positioned on the ledges 30, 31, 34, and 33 of the carrier 10 so that both permanent magnets are disposed precisely parallel to one another. The highly precise dimensions of the carrier 10 together with the alignment on the supporting ledges of the two permanent magnets assures the accuracy of the distance between the magnets which provides highly precise uniform magnetic fields at the surface of the magnetic bubble device chip.

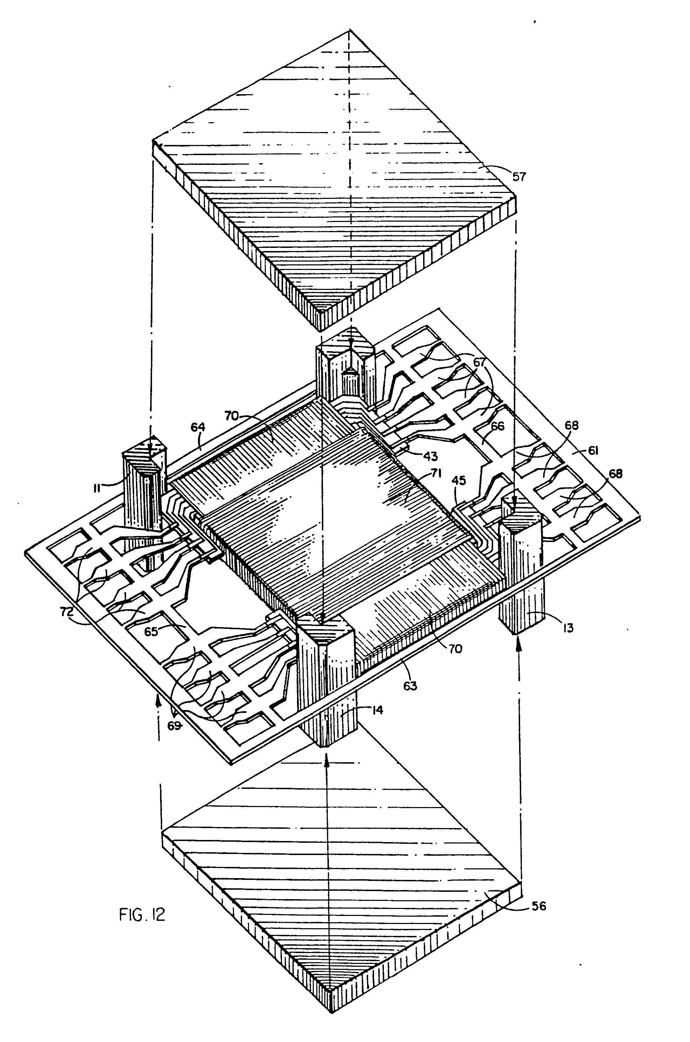

FIGURE 12 is a more detailed exploded perspective view of the partially assembled bubble domain package according to the present invention showing both the permanent magnets 56 and 57 and the external lead frame 60. The external lead frame 60 makes permanent electrical connection between external conductors and the conductors on the flexible interconnect member. The external lead frame 60 is, for example, a thin plate stamped out of a strip of 0.01 inch thick of copper or other metal having non-magnetic properties. The strip is aligned in the carrier 10 by techniques known in the art.

The strip 60 consists of two parallel bars 61 and 62 which are used in holding the metal leads 67, 68, 69 and 72, and two relatively thinner parallel bars 63 and 64.

After the leads 67, 68, 69 and 72 are bonded to the cantilevered conductive strips on the arms 43, 44, 45 and 46, the entire package is encapsulated, as will be subsequently described.

A "Z" magnetic field is provided by means of the parallel bars 63 and 64 which are positioned at opposite ends of plate 15. The "Z" magnetic field is used for calibrating the permanent magnets 56 and 57.

Following the assembly of the lead frame and the two
permanent magnets on the carrier 10, the entire package is
preferably subjected to transfer molding at a temperature of
approximately $125^{o}$C and at a pressure of approximately 600 psi.  The
transfer injection molding process effectively seals the package
and encapsulates the chip, coils, lead frame, and permanent magnets
with the carrier.  The second end portions of the electrical
leads 67, 68, 69 and 72, and the bars 61, 62 and 65 of the lead
frame extend outwardly of the insulating body and terminate in
standard connector pins.  The Z-axis bars 63 and 64 remain inside
the package.

Following the encapsulation step, the lead frame is then punched to remove the lead spacers, leaving only the leads.

Following the above step a shield (not shown), preferably composed of tubular Permalloy, is inserted over the encapsulated carrier so that the carrier is now surrounded on four sides by the shield. The remaining two opposed sides of the encapsulated carrier have the connector pins extending therefrom.

Alternatively, the assembly can be molded after the lead frame, permanent magnets, and the shield have been assembled.

It will be obvious to those skilled in the art that the magnetic bubble device package according to the present invention can be manufactured with various fabrication and packaging technologies and different combinations of known process steps, and that the preferred embodiments illustrated here are merely exemplary. The configuration and distance between the component elements, as well as their distance to the magnetic bubble device chip, can be chosen depending upon the desired properties. These and other variations can be further elaborated by those skilled in the art without departing from the scope of the present invention.

The present invention is also not restricted to the specific number or configuration of magnetic bubble domain devices and circuits described. Moreover, the orientation of the magnetic field and the static or dynamic nature of the signals applied to the device may be suitably selected as desired for a particular application.

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention, and, therefore, such adaptations should and are intended to be comprehended within the meaning and range of equivalence of the following claims.

What is claimed is:

1. A magnetic bubble domain package comprising:

a rigid carrier having a chip-receiving portion designed for receiving a circuit chip;

a circuit chip mounted on said chip-receiving portion of said carrier; and

a flexible interconnect member having a first conductive layer on a surface thereof disposed in said carrier and making physical and electrical contact with said circuit chip.

2. A magnetic bubble domain package as defined in Claim 1, wherein said rigid carrier is an integral unit composed of a synthetic plastic material; and

said chip-receiving portion is a substantially rectangular cavity disposed in the center of said carrier.

3. A magnetic bubble domain package as defined in Claim 2, wherein said cavity includes an aperture extending through said carrier; and

said circuit chip is a magnetic bubble domain device.

4. A magnetic bubble domain package as defined in Claim 1, further comprising means for generating a in-plane magnetic field for said chip comprising coil means mounted on said carrier, including a first and a second coil arranged in orthogonal relationship with respect to one another and surrounding said chip.

5. A magnetic bubble domain package as defined in Claim 1, wherein said first conductive layer of said flexible interconnect member is partitioned into a discrete number of spaced apart portions; and

said spaced apart portions comprises strips extending from said chip to the perimeter of said flexible interconnect member.

said strips cantilevering over the edge of said flexible interconnect member at the perimeter thereof.

6. A magnetic bubble domain package as defined in Claim 5, wherein said flexible interconnect member comprises a sheet having a plurality of apertures in the central portion of said member, said apertures being disposed over corresponding locations of electrical contacts on said chip.

7. A magnetic bubble domain package as defined in Claim 6, wherein said strips cantilever over the edge of said flexible interconnect member at said apertures; and

said strips are bonded at said apertures to respective electrical contacts on said chip.

8. A magnetic bubble domain package as defined in Claim 5, further comprising a metal lead frame having a plurality of selectively electrical conductors, said lead frame being mounted on said carrier so that respective first ends of said electrical conductors make electrical contact with corresponding ones of said portions of said conductive layer.

9.    A magnetic bubble domain package as defined in Claim 1, wherein said flexible interconnect member has a second conductive layer insulated from said first layer and being electrically grounded;

said second layer being configured as a substantially rectangular layer overlying said chip.


10.    A method of assembling a magnetic bubble domain package comprising the steps of:

placing a magnetic bubble domain chip on a carrier;

winding coil means on said carrier so as to surround said magnetic bubble domain chip so as to produce an in-plane rotary magnetic field at the surface of said magnetic bubble domain chip in response to electrical energization thereof;

disposing magnetic bias field means on said carrier in spaced relation to said magnetic bubble domain chip so as to produce a uniform magnetic field at a predetermined angle different from a right angle with respect to the surface of said magnetic bubble domain chip.

11.  A method as defined in Claim 10, wherein said step of winding coil means comprises winding a first coil of insulated conductive wire about the central portion of said carrier and said magnetic bubble domain chip, and winding a second coil of insulated conductive wire around the central portion of said carrier and said magnetic bubble domain chip in orthogonal relationship with said first coil; and

the step of disposing magnetic bias field means on said carrier comprises placing a substantially rectangular body of magnetic material into engagement with portions of said carrier so that said rectangular body is disposed at a predetermined angle with respect to the major surface of the magnetic bubble domain chip, and at a predetermined distance therefrom.

FIG. 1

FIG. 2

FIG. 3

FIG. 5

0032208

FIG. 4

FIG. 6

0032208

FIG.7

FIG. 8

FIG. 9

FIG. 10

FIG.11

FIG. 12